# EUROPÄISCHE PATENTSCHRIFT

(11) **EP 0 561 806 B1**
(45) Veröffentlichungstag und Bekanntmachung des Hinweises auf die Patenterteilung: **29.06.1994**
(21) Anmeldenummer: 91919763.2
(22) Anmeldetag: 15.11.1991
(51) Int. Cl.: H05K 7/20, H01L 23/40

(54) **ELEKTRISCHES GERÄT, INSBESONDERE SCHALT- UND STEUERGERÄT FÜR KRAFTFAHRZEUGE**
ELECTRICAL DEVICE, IN PARTICULAR A SWITCHING AND CONTROL DEVICE FOR MOTOR VEHICLES
DISPOSITIF ELECTRIQUE, EN PARTICULIER DISPOSITIF DE COMMUTATION ET DE COMMANDE POUR VEHICULES AUTOMOBILES

(30) Priorität: 11.12.1990 DE 9016732 U
(43) Veröffentlichungstag der Anmeldung: 29.09.1993
(73) Patentinhaber: ROBERT BOSCH GMBH, 70442 Stuttgart (DE)
(72) Erfinder: MAYER-STEUERNAGEL, Wolfgang, D-8500 Nürnberg 20 (DE); FASSEL, Reinhard, D-8507 Oberasbach (DE); KLINGER, Herbert, D-8500 Nürnberg 60 (DE); ZOEBL, Hartmut, D-8510 Fürth (DE)
(86) Internationale Anmeldenummer: DE9100892
(87) Internationale Veröffentlichungsnummer: WO9210925

(56) Entgegenhaltungen:
- EP-A- 0 295 387
- GB-A- 2 129 223
- US-A- 4 888 637

## Beschreibung

### Stand der Technik

Die Erfindung geht aus von einem elektrischen Gerät nach der Gattung des Hauptanspruchs. Bei derartigen bekannten Geräten sind sich erwärmende Leistungsbauelemente direkt auf der Leiterplatte oder auf Kühlelementen angebracht, die auf oder an der Leiterplatte oder am Gehäuse befestigt sind. Dabei sind die Leistungsbauelemente zur Erzielung eines guten Wärmeübergangs mit Federelementen an ihre Auflage angepreßt, während die Leiterplatte und/oder die Kühlelemente durch zusätzliche Verbindungsmittel wie z. B. Schrauben oder Nieten mit ihrem Gehäuse bzw. der Grundplatte des elektrischen Schaltgerätes verbunden sind. Ein derartiger Aufbau ist aufwendig und erfordert eine Vielzahl von Befestigungselementen.

### Vorteile der Erfindung

Das erfindungsgemäße elektrische Gerät mit den kennzeichnenden Merkmalen des Hauptanspruchs hat demgegenüber den Vorteil, daß bei einfachem Aufbau die Zahl der Befestigungselemente für die Leistungsbauelemente und die Leiterplatte gering ist. Darüberhinaus werden keine verschiedenartige Befestigungselemente benötigt. Durch den Aufbau des elektrischen Gerätes werden die Befestigungselemente sicher gegen unbeabsichtigtes Lösen bei der Montage und beim Betrieb des Gerätes geschützt.

### Zeichnung

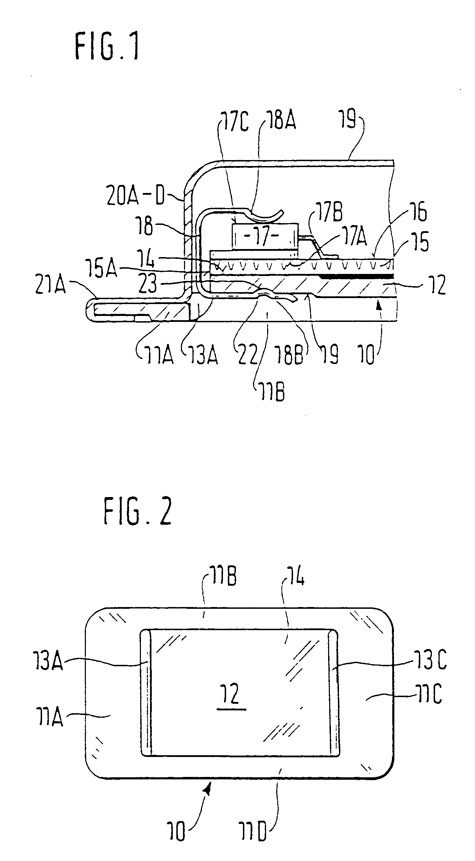

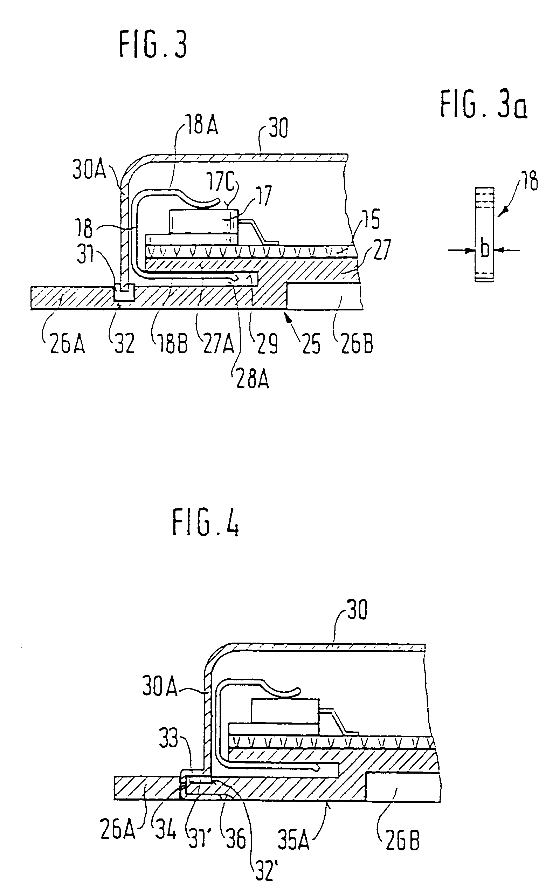

Zwei Ausführungsbeispiele der Erfindung sind in der nachfolgenden Beschreibung und Zeichnung näher erläutert. Letztere zeigt in Figur 1 einen Schnitt durch ein nur teilweise dargestelltes Steuergerät, in Figur 2 eine Draufsicht auf eine Grundplatte eines elektrischen Steuergerätes und in Figur 3 im nur teilweise dargestellten Schnitt eine weitere Ausführungsform eines elektrischen Steuergerätes. Figur 3a zeigt eine Ansicht eines Federelementes und Figur 4 eine Abwandlung des Steuergerätes nach Figur 3.

### Beschreibung der Ausführungsbeispiele

In den Figuren 1 und 2 ist mit 10 eine etwa wannenförmige Grundplatte eines elektronischen Steuergerätes bezeichnet. Diese Grundplatte besteht z. E. aus einem gestanzten Formblech mit einem umlaufenden Rand 11A - 11D und einer erhöhten, ebenen inneren Grundfläche 12. Im Bereich der jeweiligen Verbindung zwischen den Randabschnitten 11A und 11C mit der inneren Grundfläche 12 weist die Grundplatte 10 längliche Einschnitte 13A und 13C auf, die sich über die entsprechende Breite der inneren Grundfläche erstrecken.

Auf die Oberseite 14 der inneren Grundfläche ist eine Leiterplatte 15 aufgelegt, deren Abmessungen etwa denen der inneren Grundfläche entsprechen. Diese Leiterplatte 15 trägt auf ihrer Oberseite 16 eine nicht dargestellte elektronische Schaltung. An den den Einschnitten 13A und 13C zugewandten Stirnseiten 15A und 15C der Leiterplatte sind Leistungsbauelemente 17 angeordnet, deren Rückseiten 17A flächig auf der Oberseite 16 der Leiterplatte aufliegen. Die Anschlußdrähte 17B der Leistungsbauelemente sind mit Leiterbahnen auf der Oberseite der Leiterplatte elektrisch leitend verbunden, z. B. verlötet. Die Leistungsbauelemente sind mit an sich bekannten Bügelfedern 18 auf der Leiterplatte fixiert und an diese angepreßt. Diese Bügelfedern 18 sind so durch die Einschnitte 13A, 13C geschoben, daß ein Federschenkel 18A auf der Oberseite 17C des Leistungsbauelementes und der zweite Federschenkel 18B an der Unterseite 19 der inneren Grundfläche 12 anliegt. Durch diese Art der Fixierung wird das Leistungsbauelement an die Leiterplatte gepreßt. Zusätzlich wird die Leiterplatte 15 auf der Grundplatte 10 fixiert, ohne daß zusätzliche Bauelemente, wie z. B. Schrauben oder Nieten, benötigt werden.

Die elektronische Schaltung auf der Oberseite der Leiterplatte wird durch einen haubenartigen Deckel 19 geschützt. Die Abmessungen des Deckels 19 sind so gewählt, daß seine Seitenwände 20A bis 20D die Leiterplatte 15 und die innere Grundfläche 12 umrahmen. Der Deckel 19 hat an mindestens zwei gegenüberliegenden Stirnseiten Randabschnitte 21A, 21C, die auf den Randabschnitten 11A, 11C der Grundplatte aufliegen und diese überragen. Die überragenden Bereiche der Randabschnitte 21A, 21C sind zur Befestigung des Deckels um die Randabschnitte der Grundplatte herumgebördelt.

Die Bügelfedern 18 werden durch den Deckel 19 gegen Abrutschen oder Abrütteln im Betrieb dadurch gesichert, daß der Abstand zwischen dem Rücken der Bügelfeder und der Innenwand des Deckels sehr gering ist oder diesen sogar berührt, mindestens aber kleiner als die Breite b der Bügelfeder ist (Figur 3a). Zur zusätzlichen Fixierung der Federelemente können diese am Federschenkel 18B mit einer sickenförmigen Einbuchtung 22 versehen sein, die in eine entsprechende Nut 23 an der Unterseite der inneren Grundfläche ragt.

In Figur 3 ist ein zweites Ausführungsbeispiel dargestellt, das sich von dem zuvor beschriebenen dadurch unterscheidet, daß die elektronische Schaltung sicher vor dem Eindringen von Staub und Feuchtigkeit bewahrt wird. Die wannenförmige Grundplatte 25 besteht z. B. aus einem Druckgußteil und hat einen umlaufenden Rand 26A - 26D und eine erhöhte, etwa rechtwinklige innere Grundfläche 27. Die innere Grundfläche 27 ist an zwei gegenüberliegenden Stirnseiten 27A, 27C erweitert und ragt über einen Teil der Randabschnitte 26A und 26C. Zwischen den Randabschnitten 26A, 26C und den überkragenden Stirnseiten 27A, 27C der inneren Grundfläche verbleiben flache Einschuböffnungen 28A, 28C. Die Leistungsbauelemente 17 sind so mit den Federelementen 18 auf der Leiterplatte fixiert und an diese angepreßt, daß ein Federschenkel 18A auf der Oberseite 17C des Leistungsbauelementes anliegt und der zweite Federschenkel 18B in die Einschuböffnung 28A bzw. 28C ragt und an der Unterseite 29 der inneren Grundfläche anliegt.

Die Leiterplatte 15 und die innere Grundfläche sind durch einen haubenartigen Deckel 30 abgedeckt, dessen Abmessungen so gewählt sind, daß die Seitenwände 30A, 30C das Federelement gegen Abschieben sichern. Die Seitenwände 30A - 30D des Deckels 30 liegen auf einer umlaufenden Dichtung 31 auf, die in eine entsprechende Nut 32 im Rand 26A - 26D der Grundplatte eingesetzt ist. Die Dichtung 31 und der Deckel 30 sind auf geeignete Weise fest mit der Grundplatte verbunden, z. B. verklebt.

Figur 4 zeigt eine Abwandlung des Ausführungsbeispiels nach Figur 3, die sich von dem zuvor beschriebenen durch die Art der Befestigung des Deckels an der Grundplatte unterscheidet. Der Deckel 30 weist dazu an den zur Grundplatte 25 weisenden Unterseiten der Seitenwände 30A, 30C Befestigungslaschen 33 auf, die etwa rechtwinklig nach außen und anschließend wieder nach unten umgebogen sind. Die nach unten weisenden Abschnitte der Befestigungslaschen 33 ragen durch die Randabschnitte 26A, 26C der Grundplatte 25, die dazu entsprechende, längliche Öffnungen 34 aufweisen. Zur Befestigung des Deckels sind die Befestigungslaschen auf den Unterseiten 35A, 35C der Randabschnitte nach innen umgebogen. Die Seitenwände 30A - 30D des Deckels liegen auf einer umlaufenden Dichtung 31′ auf, die in eine entsprechende Nut 32′ im Rand 26A - 26D eingelegt ist. Um die Unterseite 35A, 35C der Randabschnitte 26A, 26C eben zu gestalten, können im Bereich der Öffnungen 34 Vertiefungen 36 angebracht werden, in die die Enden der Befestigungslaschen 33 eingebogen werden.

## Patentansprüche

1. Elektrisches Gerät, insbesondere Schalt- und Steuergerät für Kraftfahrzeuge, mit einer Leiterplatte (15), die eine elektronische Schaltung mit mindestens einem durch eine Bügelfeder (18) fixierten Leistungsbauelement (17) trägt, und mit einem mindestens aus einer Grundplatte (10; 25) und einem Deckel (19; 30) bestehenden Gehäuse, dadurch gekennzeichnet, daß das Leistungsbauelement (17), die Leiterplatte (15) und die Grundplatte durch die Bügelfeder (18) verbunden sind, daß die Leiterplatte samt Federelement im Inneraum des Deckels angeordnet ist und daß der Abstand des Rückens der Bügelfeder von der Innenwand des Deckels kleiner ist als die Breite des Rückens (b) der Bügelfeder.

2. Elektrisches Gerät nach Anspruch 1, dadurch gekennzeichnet, daß die Grundplatte eine erhöhte innere Grundfläche (15; 27) und einen umlaufenden Rand (11A - 11D; 26A - 26D) aufweist.

3. Elektrisches Gerät nach Anspruch 1 und/oder 2, dadurch gekennzeichnet, daß die Grundplatte (10) Einschnitte (13A, 13C) aufweist, durch die ein Schenkel (18B) der Bügelfeder (18) ragt.

4. Elektrisches Gerät nach einem der Ansprüche 1 bis 3, dadurch gekennzeichnet, daß die Bügelfeder (18) eine Einbuchtung (22) aufweist, die in eine Vertiefung (23) an der Unterseite (19) der Grundplatte (10) ragt.

5. Elektrisches Gerät nach einem der Ansprüche 1 bis 4, dadurch gekennzeichnet, daß die Grundplatte (10) aus einem gestanzten Formblech besteht.

6. Elektrisches Gerät nach Anspruch 1 und/oder 2, dadurch gekennzeichnet, daß der Deckel (30) auf einer Dichtung (31, 31′) in der Grundplatte (25) aufliegt.

7. Elektrisches Gerät nach Anspruch 6, dadurch gekennzeicnnet, daß der Deckel (30), die Dichtung (31) und die Grundplatte (25) miteinander verklebt sind.

8. Elektrisches Gerät nach Anspruch 6, dadurch gekennzeichnet, daß der Deckel (30) Befestigungslaschen (33) aufweist, die durch Öffnungen (34) in der Grundplatte (25) ragen.

9. Elektrisches Gerät nach einem der Ansprüche 1, 2, 6 bis 8, dadurch gekennzeichnet, daß die Grundplatte (25) aus einem Druckgußteil besteht.

10. Elektrisches Gerät nach einem der Ansprüche 1, 2, 6 bis 9, dadurch gekennzeichnet, daß zwischen mindestens einer Stirnseite (27A, 27C) der inneren Grundfläche und dem Rand (26A, 26C) eine Einschuböffnung (28A, 28C) angeordnet ist.

11. Elektrisches Gerät nach Anspruch 10, dadurch gekennzeicnnet, daß ein Schenkel (18B) des Federelementes in die Einschuböffnung ragt.

## Claims

1. Electrical device, in particular a switching and control device for motor vehicles, having a printed-circuit board (15) which bears an electronic circuit with at least one power component (17) which is fixed by a spring bracket (18), and having a housing which consists at least of one base plate (10; 25) and one cover (19; 30), characterized in that the power component (17), the printed-circuit board (15) and the base plate are connected by the spring bracket (18), in that the printed-circuit board together with spring element is arranged inside the cover, and in that the distance between the back of the spring bracket and the inner wall of the cover is smaller than the width of the back (b) of the spring bracket.

2. Electrical device according to Claim 1, characterized in that the base plate has an elevated, inner base face (15; 27) and a peripheral edge (11A - 11D; 26A - 26D).

3. Electrical device according to Claim 1 and/or 2, characterized in that the base plate (10) has indents (13A, 13C) through which a leg (18B) of the spring bracket (18) protrudes.

4. Electrical device according to one of Claims 1 to 3, characterized in that the spring bracket (18) has a bent portion (22) which protrudes into a depression (23) on the underside (19) of the base plate (10).

5. Electrical device according to one of Claims 1 to 4, characterized in that the base plate (10) consists of a punched sheet metal preform.

6. Electrical device according to Claim 1 and/or 2, characterized in that the cover (30) rests on a seal (31, 31′) in the base plate (25).

7. Electrical device according to Claim 6, charac- terized in that the cover (30), the seal (31) and the base plate (25) are bonded to one another.

8. Electrical device according to Claim 6, characterized in that the cover (30) has attachment clips (33) which protrude through openings (34) in the base plate (25).

9. Electrical device according to one of Claims 1, 2, 6 to 8, characterized in that the base plate (25) consiste of a pressure die-cast part.

10. Electrical device according to one of Claims 1, 2, 6 to 9, characterized in that an insertion opening (28A, 28C) is arranged between at least one end side (27A, 27C) of the inner base face and the edge (26A, 26C).

11. Electrical device according to Claim 10, characterized in that a leg (18B) of the spring element protrudes into the insertion opening.

## Revendications

1. Dispositif électrique notamment dispositif de commutation et de commande pour véhicules automobiles, comportant une plaque de circuit imprimé (15) portant un circuit électronique avec au moins un composant de puissance (17) fixé par un étrier élastique (18) et un boîtier formé d'au moins une plaque de base (10 ; 25) et d'un couvercle (19 ; 30), caractérisé en ce que le composant de puissance (17), la plaque de circuit imprimé (15) et la plaque de base sont reliés par des étriers élastique (18), la plaque de circuit imprimé ainsi que l'élément élastique étant logés dans le couvercle et la distance du dos de l'étrier élastique et de la paroi intérieure du couvercle est inférieure à la largeur (b) du dos de l'étrier élastique.

2. Dispositif électrique selon la revendication 1, caractérisé en ce que la plaque de base présente une surface de base (15 ; 27), intérieure, surélevée et un bord périphérique (11A-11D ; 26A-26D).

3. Dispositif électrique selon la revendication 1 et/ou 2, caractérisé en ce que la plaque de base (10) comporte des encoches (13A, 13C) traversées par une branche (18B) de l'étrier élastique (18).

4. Dispositif électrique selon l'une des revendications 1 à 3, caractérisé en ce que l'étrier élastique (18) comporte une dentelure(22) pénétrant dans une cavité (23) de la face inférieure (19) de la plaque de base (10).

5. Dispositif électrique selon l'une des revendications 1 à 4, caractérisé en ce que la plaque de base (10) est une pièce en tôle estampée.

6. Dispositif électrique selon la revendication 1 et/ou 2, caractérisé en ce que le couvercle (30) s'appuie sur un joint (31, 31') de la plaque de base (25).

7. Dispositif électrique selon la revendication 6, caractérisé en ce que le couvercle (30), le joint (31) et la plaque de base (25) sont collés.

8. Dispositif électrique selon la revendication 6, caractérisé en ce que le couvercle (30) comporte des pattes de fixation (33) traversant des ouvertures (34) de la plaque de base (25).

9. Dispositif électrique selon l'une des revendications 1, 2, 3, 6 à 8, caractérisé en ce que la plaque de base (25) est une pièce injectée sous pression.

10. Dispositif électrique selon l'une des revendications 1, 2, 6-9, caractérisé en ce qu'entre au moins une face frontale (27A, 27C) de la surface de base intérieure et le bord (26A, 26C) on a un logement (28A, 28C).

11. Dispositif électrique selon la revendication 10, caractérisé en ce qu'une branche (18B) de l'élément élément élastique se glisse dans le logement.
